(19) Europäisches Patentamt
European Patent Office
Office européen des brevets

(11) **EP 3 309 971 B1**

(12) **EUROPEAN PATENT SPECIFICATION**

(45) Date of publication and mention
of the grant of the patent:
**22.05.2024 Bulletin 2024/21**

(21) Application number: **16832221.2**

(22) Date of filing: **22.07.2016**

(51) International Patent Classification (IPC):
**H03M 13/15** *(2006.01)*

(52) Cooperative Patent Classification (CPC):
**H03M 13/1515; H03M 13/1525; H03M 13/157;
H03M 13/158; H03M 13/1585; H03M 13/159**

(86) International application number:
**PCT/CN2016/091012**

(87) International publication number:
**WO 2017/020733 (09.02.2017 Gazette 2017/06)**

(54) **METHOD FOR ENCODING AND DECODING OF REED-SOLOMON CODES**

VERFAHREN ZUR ENKODIERUNG UND DEKODIERUNG VON REED-SOLOMON KODES

PROCÉDÉ DE CODAGE ET DE DÉCODAGE DES CODES REED-SOLOMON

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.07.2015 CN 201510461188**

(43) Date of publication of application:
**18.04.2018 Bulletin 2018/16**

(73) Proprietor: **Ingenico (Fujian) Technology Co., Ltd.
Fujian 350001 (CN)**

(72) Inventors:
• **JIANG, Shengzhang
Fuzhou
Fujian 350000 (CN)**
• **WU, Weidong
Fuzhou
Fujian 350000 (CN)**
• **WANG, Mingwei
Fuzhou
Fujian 350000 (CN)**

(74) Representative: **LLR
2, rue Jean Lantier
75001 Paris (FR)**

(56) References cited:
**EP-A1- 1 037 148         EP-A2- 0 609 188
WO-A2-01/17154          CN-A- 1 447 528
CN-A- 101 442 313       CN-A- 105 024 707
CN-U- 201 541 254       US-B1- 6 263 470**

• **C K P Clarke: "Reed-Solomon error correction",
BBC R&D White Paper, 1 July 2002 (2002-07-01),
XP55095300, Retrieved from the Internet:
URL:http://downloads.bbc.co.uk/rd/pubs/whp
/whp-pdf-files/WHP031.pdf [retrieved on
2014-01-08]**

**Description**

<u>**FIELD OF THE INVENTION**</u>

The present invention relates to the technical field of error correction codes, and in particular to a Reed-Solomon (RS) error correction decoding method.

<u>**BACKGROUND OF THE INVENTION**</u>

In a communication system, it is necessary to artificially add redundant codes to the data stream according to certain rules before information is sent so that a receiving terminal can detect and correct error codes. RS error correction code is currently one of the most effective and widely used error control encoding measures. RS codes can be used to correct random errors, and are also suitable for correcting burst errors, and have been widely used in areas such as satellite communications, digital television transmission or the like.

(c, k, 2t) are typically used to represent RS codes; where c is the total length of information data and redundant code, k is the length of the information data, 2t is the length of the redundant code, and t is the maximum number of errors that can be corrected, where c=K+2t.

The number of elements in the Galois field (GF) in the conventional RS error correction algorithm is related to the number of primitive polynomials. For example, if the order of a primitive polynomials is 8, then the number of elements in the GF is $2^8$, i.e., 256, the elements in the GF are used for a lookup table in the RS error correction calculation process, and the number of elements in the lookup table reaches 256; and if the order of a primitive polynomial is 16, then the number of elements in the GF is $2^{16}$, i.e., 65536, which occupies more memory space, and therefore the speed of data processing is slow and the application thereof is limited. In addition, if the number of actual error code words exceeds the error correction capacity, a situation that more errors occur as the error correction proceeds may arise.

In addition, in conventional RS error correction algorithms, the error codes are not checked after being found and corrected, so the stability and correctness of the system is not high.

Chinese invention patent publication No. CN1303763C discloses a method for reducing the complexity of encoding and decoding RS codes. The invention has the following main features: when encoding at a sending terminal, the code element of the RS code is represented by the power of the primitive field element $\alpha$, and code words of the RS codes are all in the finite field GF ($2^m$), and all non-zero elements in the finite field GF ($2^m$) are integer powers of the primitive field element $\alpha$. In coding and decoding, for any two elements X and Y in the finite field GF ($2^m$), multiplication of X and Y equals to addition of the corresponding two exponents, and the addition and subtraction of X and Y are performed using a lookup table. In this way, the coding and decoding method is improved based on existing RS coding and decoding algorithms, the complicated multiplication operation can be avoided and the coding and decoding speed is improved. However, for the finite field GF ($2^m$), three lookup tables have to be established, i and x' in each group are stored in two long lookup tables, power [] and index [], and there is a further lookup table f(s), where s is selected from all the integers ranging from 0 to $2^m$-1, with a total number of $2^m$. While the calculation speed is fast, the data memory occupied is relatively large, and after the RS error codes are corrected using the redundant codes, no valid data are used for checking, resulting in low security and stability. In an article entitled "Reed-Solomon error correction" (BBC R&D White Paper, WHP 031), of July 2002, by C.K.P. Clarke, basics about Reed-Solomon encoding and decoding are described, including the underying mathematics and with emphasis on realization of the respective algorithms in logical circuits. The use of look-up tables for implementing Galois field multiplications, divisions and additions is described.

According to WO 01/17154 A2, during encoding, a microprocessor calculates $Y_m$ by standard Reed-Solomon encoding techniques. The microprocessor then utilizes Ym as an index to a look-up table, and is returned $G_0Y_m$, $G_1Y_m$, ..., $G_{K-1}Y_m$, from the look-up table. During syndrome calculation, a second set of parity symbols are generated from the information symbols using the method similar to the encoder, in particular, values for $G_0Y_m$, ..., $G_KY_m$ are obtained from a first look-up table in a similar manner as encoder to determine the values for $GoYm$, $G_1Y_m$, ..., $G_{K-1}Y_m$. A second look-up table is set up to determine roots of the error locator polynomial. The second look-up table consists of several tables and each table contains (Q-1) elements, where Q is the size of the GF(Q) field. The mth look-up table stores Galois Field element alpha$^{-mi}$ at location i if the greatest common denominator between (Q-1) and m (GCD(Q-1,m))=1. If GCD(Q-1,m)$\neq$1, then the mth look-up table actually consists of (GCD(Q-1,m)) sub-tables storing GF element alpha$^{-(mi+j)}$, where j=0, 1, ..., GCD(Q-1,m)-1.

In US 6,263,470 B1 a programmable logic device as may be used in a communication system device such as a digital subscriber line modem to perform Reed-Solomon decoding upon a received frame of digital values is disclosed. The programmable logic device may be implemented as a DSP or a general purpose microprocessor, for example. A group of look-up tables are arranged, each look-up table is associated with one of the possible power values of a finite field, number up to twice the number of correctable errors. The contents of each entry (SYN) of the look-up tables correspond to the finite field (e.g., Galois field) multiplication of a primitive element raised to an index power with a character of the finite field alphabet. Galois field multiplications in syndrome accumulation may now be performed with a single table look-up operation. According to other disclosed embodiments of the invention, look-up tables are similarly arranged to contain the contents of finite field (e.g., Galois field) multiplication products for use in a Chien search procedure. In a single-thread version of the disclosed Chien search procedure, a subset of the same look-up tables as used in syndrome accumulation may be utilized.

## SUMMARY OF THE INVENTION

The technical problem to be addressed by the present invention is to provide a RS error correction decoding method which occupies less memory.

In order to address the above technical problem, the invention provides technical solutions as defined in the appended claims.

The description that follows is subjected to this limitation. Any disclosure lying outside the scope of said claims is only intended for illustrative as well as comparative purposes.

The invention has the following advantageous effects: a lookup table $f(\alpha^j)$ consisting of 2m exponents of the primitive field element $\alpha$ is established in the finite field GF ($2^m$) to calculate the coefficients of the generator polynomial $G(x)$ and the coefficients of the remainder polynomial $R(x)$ obtained by dividing the code word polynomial $Q(x)$ by the generator polynomial $G(x)$, and the number of data in the lookup table $f(\alpha^j)$ is greatly reduced, thus saving a great deal of system memory and improving the flexibility and convenience in applying the RS error correction algorithm.

## BRIEF DESCRIPTION OF THE ACCOMPANYING DRAWINGS

Figure 1 is a flowchart of performing RS encoding by a sending terminal according to a first embodiment of the present invention; and

Figure 2 is a flowchart of RS encoding and error correction according to the first embodiment of the present invention.

## DETAILED DESCRIPTION OF THE PREFERRED EMBODIMENTS

The disclosure, objects and effects of the present invention will be described in detail below with reference to the embodiments and accompanying drawings.

The critical concept of the present invention is to establish a lookup table $f(\alpha^j)$ for different power exponents of $\alpha$ for a m-order primitive polynomial $P(x)$, where j is selected from all the integers ranging from 0 to 2m-1, with a total number of 2m, for the calculation of coefficients of a generator polynomial $G(x)$ and coefficients of a remainder polynomial $R(x)$ obtained by dividing a code word polynomial $Q(x)$ by the generator polynomial $G(x)$, thus greatly saving the system memory; and a redundant code is additionally taken during encoding, for checking the data obtained by error correction decoding so as to improve system correctness and stability.

The technical term involved in the present invention is explained in Table 1:

Table 1

| Technical term | Interpretation |
| --- | --- |
| polynomial representation | A number is represented by a sum of a group of bases $(1, \alpha, \alpha^2, ..., \alpha^{n-1})$, and the group of bases are referred to as standard bases |

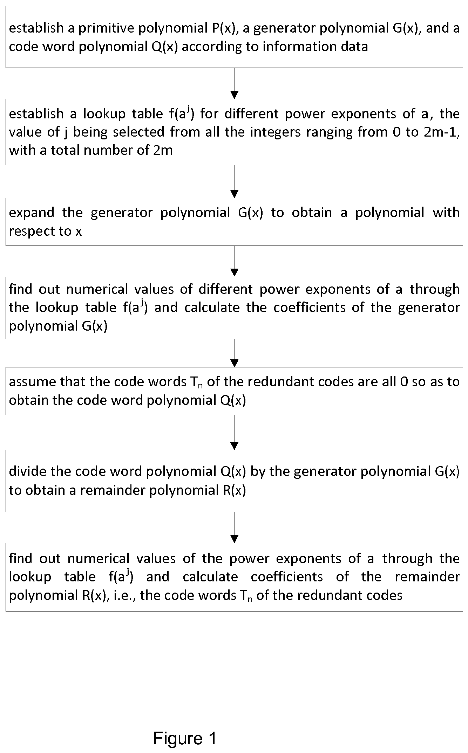

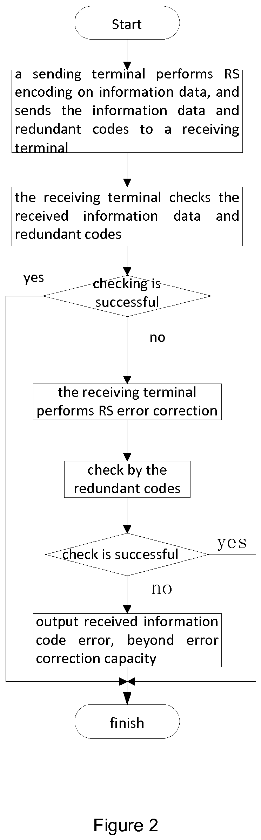

Referring to Figure 1 and Figure 2, a specific embodiment of the present invention is described as follows.

A RS error correction encoding and decoding method is provided, in which,

when encoding at a sending terminal, code words of information data are represented by $K_l$, code words of redundant codes are represented by $T_n$, the order of primitive polynomial $P(x)$ is m, a generator polynomial in $GF(2^m)$ is $G(x)$, and an error correction code is represented by (c, k, t), wherein c is the total length of the information data and the redundant code, k is the length of the information data, and t is the length of the redundant code, then the code

$$Q(x) = \sum_{l=t}^{t+k-1} K_l \cdot x^l + \sum_{n=0}^{t-1} T_n \cdot x^n$$

word polynomial $Q(x)$ can be represented as                     ; root of the m-order primitive polynomial P(x) is primitive field element in GF ($2^m$), and the primitive field element is represented by $\alpha$, thus the

$$G(x) = \prod_{i=1}^{t} \left( x - \alpha^i \right)$$

generator polynomial G(x) can be represented as ;

a lookup table $f(\alpha^j)$ is established for different power exponents of $\alpha$, wherein the value of j is selected from all the integers ranging from 0 to 2m-1, with a total number of 2m;

the generator polynomial G(x) is expanded to obtain a polynomial with respect to x, wherein the coefficients of the generator polynomial G(x) are the addition or subtraction of the power exponents of $\alpha$;

numerical values of the different power exponents of $\alpha$ are found out through the lookup table $f(\alpha^j)$ and the coefficients of the generator polynomial G(x) are calculated;

it is assumed that the code words $T_n$ of the redundant codes are all 0, then a code word polynomial

$$Q(x) = \sum_{l=t}^{t+k-1} K_l \cdot x^l$$

is obtained;

the code word polynomial Q(x) is divided by the generator polynomial G(x) to obtain a remainder polynomial

$$R(x) = \sum_{i=0}^{2s} T_i \cdot x_i$$

;

the coefficients Ti of R(x) are the addition or subtraction of the power exponents of $\alpha$; numerical values of the power exponents of $\alpha$ are found out through the lookup table $f(\alpha^j)$, and the coefficients of the remainder polynomial R(x) are calculated, namely, the code word Tn of the redundant codes.

Further, the error correction decoding process is described as follows:

it is assumed that s is the maximum number of error correction bits of a receiving terminal, let t=2s+1;

the code word polynomial Q(x) is divided by the generator polynomial G(x) to obtain the remainder polynomial R(x),

$$R(x) = \sum_{i=0}^{2s} T_i \cdot x_i$$

;

the coefficients of the remainder polynomial R(x) are calculated, thus obtaining the code words $T_n$ of 2s+1 redundant codes, n=1, 2, ..., 2s+1;

the sending terminal sends information data and 2s+1 redundant codes to the receiving terminal;

the receiving terminal receives the information data and 2s+1 redundant codes;

the receiving terminal obtains the code word polynomial Q(x) by coding according to the received information data and 2s+1 redundant codes, and the code word polynomial Q(x) is represented as

$$Q(x) = \sum_{l=2s+1}^{2s+k} K_l \cdot x^l + \sum_{n=0}^{2s} T_n \cdot x^n$$

;

the receiving terminal calculates 2s+1 correctors $S_i$, where $S_i=Q(\alpha^i)$, i=1, 2, ..., 2s+1;

a location and a correction value of error information code are calculated using correctors $S_1$ to $S_{2s}$ if not all of the correctors $S_i$ are equal to 0;

the correction value is added to the code word at the location of the error information code received by the receiving terminal to obtain an error-corrected code word;

the value of the error-corrected code word is assigned to the code word at the location of the error information code;

$S_{2s+1}=Q(\alpha^{2s+1})$ is recalculated, and if $S_{2s+1}=0$, the error correction is successful, and if $S_{2s+1}\neq0$, received information code error is output and the error correction capacity is insufficient for this.

As can be seen from the above description, 2s+1 redundant codes are obtained when the 0th power of x is taken in calculating the redundant codes, and after the error correction codes are calculated using the 1st to the 2sth redundant codes, the (2s+1)th redundant code is used to check whether the error-corrected code word polynomial is correct. In this way, the correctness of the error correction operation is effectively ensured, and the stability of system operation is improved.

Further, in the process of obtaining the remainder polynomial R(x) by dividing the code word polynomial Q(x) by the generator polynomial G(x), multiplication of the coefficients of x will be performed, and the multiplication is converted into addition in operation as follows.

the coefficients of x are represented by a polynomial representation;

the coefficients represented by the polynomial representation are multiplied and expanded to obtain addition of different power exponents of $\alpha$;

the numerical values of the different power exponents of $\alpha$ are found out by looking up the lookup table $f(\alpha^j)$ so as to solve the addition.

Further, the specific process of calculating the location of the error information code using the correctors $S_1$ to $S_{2s}$ is described as follows:

a calculation is performed based on the correctors to obtain an equation taking the location of the error information code as a root;

the root of the equation is represented by a polynomial representation, with standard bases being different power exponents of $\alpha$ and coefficients being values of $X_i$, where i=0, 1, ..., m;

the coefficients of the equation are represented by a polynomial representation, with standard bases being different power exponents of $\alpha$;

the root and coefficients represented by the polynomial representations are brought into the polynomial of the equation;

let the coefficient of each term of the polynomial be zero, thus obtaining a non-homogeneous linear equations set for $x_i$;

the non-homogeneous linear equation set is solved to obtain the value of $x_i$;

the value of $x_i$ is brought into the root represented by the polynomial representation to calculate the root of the equation and obtain the location of the error information code;

the location in the code word polynomial Q(x) corresponding to the location of the error information code is looked for.

Further, looking for the location in the code word polynomial Q(x) corresponding to the location of the error information code is specifically as follows:

a numerical value that is the same as the value of the error information code is looked for in the lookup table $f(\alpha^j)$, and the coefficient at the location where the exponent value of x in the polynomial Q(x) is equal to the exponent value of $\alpha$ corresponding to the numerical value is the location in the code word polynomial Q(x) corresponding to the error information code;

if the numerical value that is the same as the value of the error information code is not found in the lookup table $f(\alpha^j)$, the following method is used to find out the location of the error information code, specifically:

in step S1, take p=2*m-1=31, $v=\alpha^{2m-1}$.

in step S2, let p=p + 1;

in step S3, if the highest data bit of v is 1, v is firstly shifted leftward by 1 bit, and then $v=v+v_0$, where $v_0$ is the numerical value obtained by bringing $x=\alpha$ into the primitive polynomial P(x) except for the term of the highest power of x;

if the highest data bit of v is 0, v is shifted leftward by 1 bit;

in step S4, the v obtained in step S3 is compared with the error information code to see if they are equal:

if the v is equal to the error information code, the coefficient corresponding to the pth power of x in the code word polynomial Q (x) is the location of the error information code; and

If the v is not equal to the error information code, then turn to step S2 to continue the process.

Further, using the correctors $S_1$ to $S_{2s}$ to calculate the correction value is specifically as follows:

a equation set consisting of the location of the error information code and the correction value is obtained, where the error information code is the root of the equation set, and the correction value is an unknown number of the equation set;

the correction value of the equation set is represented by the polynomial representation, with standard bases being different power exponents of $\alpha$, and coefficients being values of $x_i$, i=0, 1, ..., m;

the location of the error information code of the equation set is represented by the polynomial representation, with standard bases being different power exponents of $\alpha$;

the correction value and coefficients represented by the polynomial representation are brought into the polynomial of the equation set;

let the coefficient of each term of the polynomial be zero, thus obtaining a non-homogeneous linear equation set for $x_i$;

the non-homogeneous linear equation set is solved to obtain the value of $x_i$;

the value of $x_i$ is brought into the correction value represented by the polynomial representation so as to calculate the root of the equation set and obtain the correction value.

It can be seen from the above description that in the process of error correction decoding of RS operation, the coefficients and unknown numbers of polynomials are all represented by the polynomial representation, thus the multiplication operation can be converted into addition operation, and solving of equation or equation set can be converted into solving of the non-homogeneous linear equation set so that the complicated operations are simplified, and the calculation process is simplified. The requirements on hardware are reduced, and the correctness of system operation is improved. If the numerical value that is being looked for is beyond the numerical value range of the lookup table $f(\alpha^j)$, the numerical value can be calculated by exponential operation. Since the data beyond the numerical value range of the lookup table $f(\alpha^j)$ is less in the process of RS error correction decoding, only 2m data are established in the lookup table $f(\alpha^j)$, and the memory consumption is therefore reduced.

Referring to Figure 1 and Figure 2, the first embodiment of the present invention is described as follows.

A RS error correction encoding and decoding method is provided, in which when encoding at a sending terminal, five code words of information data, 0x1234, 0x5678, 0x3245, 0xabcd, 0xef10, are represented by $K_l$, l= 5, and the primitive polynomial is $P(x)=x^{16}+x^5+x^3+x^2+1$, the order of the primitive polynomial is 16, and for a generator polynomial in the $GF(2^{16})$, k is the length of information data, then, k is 5, t is the length of the redundant code, s is the maximum number of error correction bits by the receiving end and is 2; when taking t=2s+1, then t=5, c is the total length of the information data and the redundant code and is 10, the error correction code is represented by (c, k, t), then (c, k, t) is (10, 5, 5), $T_n$ represents the code words of the redundant codes, n=1, 2, ..., 5, then the code word polynomial Q(x) can be represented as

$$Q\left(x\right) = \sum_{l=t}^{t+k-1} K_l \cdot x^l + \sum_{n=0}^{t-1} T_n \cdot x^n \quad ;$$

a root of the 16-order primitive polynomial P(x) is a primitive field element in $GF(2^{16})$, and the primitive field element

$$G\left(\mathrm{x}\right) = \prod_{i=1}^{5}\left(x - \alpha^i\right)$$

is represented by $\alpha$, then the generator polynomial G(x) can be represented as ;

a lookup table $f(\alpha^j)$ for different power exponents of $\alpha$ is established, where the value of j is selected from all the integers ranging from 0 to 31, with a total number of 2m, specifically:

{1,2,4,8,0x10,0x20,0x40,0x80,0x100,0x200,0x400,0x800,0x1000,0x2000, 0x4000,0x8000,0x2d,0x5a,0xb4,0x168.0x2d0,0x5a0,0xb40,0x1680,0x2d00, 0x5a00,0xb400,0x682d,0xd05a,0xa099,0x411f,0x823e};

the generator polynomial G(x) is expanded to obtain a polynomial with respect to x, where the coefficients of the generator polynomial G(x) are addition or subtraction of the power exponents of $\alpha$, specifically:

$$G(\mathrm{x}) = \prod_{i=1}^{5}\left(x-\alpha^i\right) = \left(x-\alpha\right)\left(x-\alpha^2\right)\left(x-\alpha^3\right)\left(x-\alpha^4\right)\left(x-\alpha^5\right)$$

$$= x^5 + \left(\alpha + \alpha^2 + \alpha^3 + \alpha^4 + \alpha^5\right)x^4 + \left(\alpha^3 + \alpha^4 + \alpha^8 + \alpha^9\right)x^3 \quad ;$$

$$+ \left(\alpha^7 + \alpha^8 + \alpha^{11} + \alpha^{12}\right)x^2 + \left(\alpha^{10} + \alpha^{11} + \alpha^{12} + \alpha^{13} + \alpha^{14}\right)x + \alpha^{15} \quad ;$$

numerical values of the different power exponents of $\alpha$ are found out through the lookup table $f(\alpha^j)$ and the coefficients of the generator polynomial G(x) are calculated, specifically: $G(x) = x^5 + 0x3e * x^4 + 0x318 * x^3 + 0x18c0 * x^2 + 0x7c00 * x + 0x8000$ ;

it is assumed that each code word $T_n$ of the redundant codes is 0, then the code word polynomial

$$Q(x) = \sum_{l=t}^{t+k-1} K_l \cdot x^l$$

is obtained, specifically:

$$Q(x) = 0x1234 * x^9 + 0x5678 * x^8 + 0x3245 * x^7 + 0xabcd * x^6$$
$$+ 0xef10 * x^5 + 0 * x^4 + 0 * x^3 + 0 * x^2 + 0 * x^1 + 0 * x^0 \quad ;$$

the code word polynomial Q(x) is divided by the generator polynomial G(x) to obtain a remainder polynomial

$$R(x) = \sum_{i=0}^{2s} T_i \cdot x_i \quad .$$

In calculating the remainder polynomial R(x), multiplication of coefficients of x will be performed, and the multiplication operation is converted into addition operation, specifically:

0x1234*0x18c0 is taken as an example;
the coefficients of x in the code word polynomial Q(x) and the generator polynomial G(x) are represented by a polynomial representation, specifically:

$$0x1234 = 0*\alpha^{15} + 0*\alpha^{14} + 0*\alpha^{13} + 1*\alpha^{12} + 0*\alpha^{11} + 0*\alpha^{10} + 1*\alpha^9 + 0*\alpha^8 + 0*\alpha^7$$

$$+ 0*\alpha^6 + 1*\alpha^5 + 1*\alpha^4 + 0*\alpha^3 + 1*\alpha^2 + 0*\alpha^1 + 0*\alpha^0$$

$$= \alpha^{12} + \alpha^9 + \alpha^5 + \alpha^4 + \alpha^2;$$

$$0x18c0 = 0*\alpha^{15} + 0*\alpha^{14} + 0*\alpha^{13} + 1*\alpha^{12} + 1*\alpha^{11} + 0*\alpha^{10} + 0*\alpha^9$$

$$+ 0*\alpha^8 + 1*\alpha^7 + 1*\alpha^6 + 0*\alpha^5 + 0*\alpha^4 + 0*\alpha^3 + 0*\alpha^2 + 0*\alpha^1 + 0*\alpha^0$$

$$= \alpha^{12} + \alpha^{11} + \alpha^7 + \alpha^6;$$

the coefficients represented by the polynomial representation are multiplied and expanded to obtain addition of different power exponents of $\alpha$:

$$0x1234 * 0x18c0 = (\alpha^{12} + \alpha^9 + \alpha^5 + \alpha^4 + \alpha^2) * (\alpha^{12} + \alpha^{11} + \alpha^7 + \alpha^6)$$

$$= \alpha^{24} + \alpha^{21} + \alpha^{17} + \alpha^{16} + \alpha^{14} + \alpha^{23} + \alpha^{20} + \alpha^{16} + \alpha^{15} + \alpha^{13} +$$

$$\alpha^{19} + \alpha^{16} + \alpha^{12} + \alpha^{11} + \alpha^9 + \alpha^{18} + \alpha^{15} + \alpha^{11} + \alpha^{10} + \alpha^8$$

$$= \alpha^{24} + \alpha^{23} + \alpha^{21} + \alpha^{20} + \alpha^{19} + \alpha^{18} + \alpha^{17} + \alpha^{16} + \alpha^{14} + \alpha^{13} + \alpha^{12} + \alpha^{10} + \alpha^9 + \alpha^8$$

$$= 0x2d00 + 0x1680 + 0x5a0 + 0x2d0 + 0x168 + 0xb4 + 0x5a + 0x2d$$

$$+ 0x4000 + 0x2000 + 0x1000 + 0x400 + 0x200 + 0x100$$

$$= 0x4a5b;$$

the numerical values of the power exponents of $\alpha$ are found out through the lookup table $f(\alpha^j)$, and the coefficients of the remainder polynomial R(x), i.e., the code words of the redundant codes $T_n$, n=1, 2,..., 5, are calculated; the remainder polynomial R(x) is obtained:

$$R(x) = 0x15d4 * x^4 + 0x2606 * x^3 + 0x3587 * x^2 + 0x417e * x^1 + 0x121c * x^0$$

;

code words of the five redundant codes are 0x15d4, 0x2606, 0x3587, 0x417e, 0x121c; the sending terminal sends five information data and five redundant codes 0x1234, 0x5678, 0x3245, 0xabcd, 0xef10, 0x15d4, 0x2606, 0x3587, 0x417e, 0x121c to the receiving terminal.

It is assumed that the third information data and the third redundant code received by the receiving terminal are in error, then the information data and the redundant codes received by the receiving terminal are 0x1234, 0x5678, 0xe305, 0xabcd, 0xef10, 0x15d4, 0x2606, 0xa513, 0x417e , 0x121c.

The code word polynomial Q(x) obtained by the receiving terminal according to the received information data and redundant codes is:

$$Q(x) = 0x1234 * x^9 + 0x5678 * x^8 + 0xe305 * x^7 + 0xabcd * x^6 + 0xef10 * x^5$$
$$+ 0x15d4 * x^4 + 0x2606 * x^3 + 0xa513 * x^2 + 0x417e * x^1 + 0x121c * x^0$$

.

The receiving terminal calculates five correctors $S_i$, where $S_i = Q(\alpha^i)$, i=1, 2, ..., 5, specifically,

$$S_1 = Q(\alpha^1) = 0xed82;$$

$$S_2 = Q(\alpha^2) = 0xc556;$$

$$S_3 = Q(\alpha^3) = 0x879a;$$

$$S_4 = Q(\alpha^4) = 0x4eb7;$$

$$S_5 = Q(\alpha^5) = 0x7cb9;$$

if not all of the correctors $S_i$ are equal to 0, then the location of the error information code and the correction value are calculated using the correctors $S_1$ to $S_{2s}$; specifically, calculation is performed according to the correctors to obtain the equation $SS_2 \cdot x^2 + SS_1 \cdot x + SS_0 = 0$, and the root of the equation is the location of the error code.

Let $S_1 = (S_1\ S_2)$, $S_2 = (S_2\ S_3)$, $S_3 = (S_3\ S_4)$, then

$$SS_2 = \left| \mathbf{S_1}^T \quad \mathbf{S_2}^T \right| = S_2 * S_2 + S_1 * S_3 = 0x219f;$$

$$SS_1 = \left| \mathbf{S_1}^T \quad \mathbf{S_3}^T \right| = S_4 * S_1 + S_3 * S_2 = 0x4b2c;$$

$$SS_0 = \left| \mathbf{S_2}^T \quad \mathbf{S_1}^T \right| = S_4 * S_2 + S_3 * S_3 = 0x3537;$$

then the equation is $0x219f \cdot x^2 + 0x4b2c \cdot |x + 0x3537 = 0$, and the solution to this equation is as follows:

the roots of the equation are represented by the polynomial representation, that is, x and $x^2$ are represented by the polynomial representation as:

$$x = x_{15}\alpha^{15} + x_{14}\alpha^{14} + x_{13}\alpha^{13} + x_{12}\alpha^{12} + x_{11}\alpha^{11} + x_{10}\alpha^{10} + x_9\alpha^9$$
$$+ x_8\alpha^8 + x_7\alpha^7 + x_6\alpha^6 + x_5\alpha^5 + x_4\alpha^4 + x_3\alpha^3 + x_2\alpha^2 + x_1\alpha^1 + x_0\alpha^0;$$
$$x^2 = x_{15}\alpha^{30} + x_{14}\alpha^{28} + x_{13}\alpha^{26} + x_{12}\alpha^{24} + x_{11}\alpha^{22} + x_{10}\alpha^{20} + x_9\alpha^{18} + x_8\alpha^{16}$$
$$+ x_7\alpha^{14} + x_6\alpha^{12} + x_5\alpha^{10} + x_4\alpha^8 + x_3\alpha^6 + x_2\alpha^4 + x_1\alpha^2 + x_0\alpha^0;$$

where $x_i$ can only take 0 or 1, i = 1, 2, ..., 15;
the values of x and $x^2$ are brought into the left of the equation to obtain

$$0x219f * x^2 + 0x4b2c * x + 0x3537$$
$$= 0xe006x_{15} + 0xe5c6x_{14} + 0x1799x_{13} + 0x1292x_{12} + 0x2f1bx_{11}$$
$$+ 0x1e19x_{10} + 0x2d6cx_9 + 0xbe3dx_8 + 0x3537x_7 + 0x6d1fx_6$$
$$+ 0xoeabx_5 + 0x28f9x_4 + 0x3f92x_3 + 0x3527x_2 + 0x1024x_1 + 0x6ab3x_0;$$

the exponents of $\alpha$ corresponding to the coefficients of $x_i$ are looked for in the lookup table $f(\alpha^j)$, and the left side of the equation is converted into the expression of the exponents of $\alpha$ and $x_i$, specifically:

$$0x219f*x^2+0x4b2c*x+0x3537$$

$$=0xe006x_{15}+0xe5c6x_{14}+0x1799x_{13}+0x1292x_{12}+0x2f1bx_{11}$$

$$+0x1e19x_{10}+0x2d6cx_9+0xbe3dx_8+0x3537x_7+0x6d1fx_6$$

$$+0xoeabx_5+0x28f9x_4+0x3f92x_3+0x3527x_2+0x1024x_1+0x6ab3x_0$$

$$=(x_0+x_2+x_4+x_5+x_6+x_7+x_8+x_{10}+x_{11}+x_{13}+1)*\alpha^0$$

$$+(x_0+x_2+x_3+x_5+x_6+x_7+x_{11}+x_{12}+x_{14}+x_{15}+1)*\alpha^1$$

$$+(x_1+x_2+x_6+x_7+x_8+x^9+x_{14}+x_{15}+1)*\alpha^2$$

$$+(x_4+x_5+x_6+x_8+x_9+x_{10}+x_{11}+x_{13}+0)*\alpha^3$$

$$+(x_0+x_2+x_3+x_4+x_6+x_7+x_8+x_{10}+x_{11}+x_{12}+x_{13}+1)*\alpha^4$$

$$+(x_0+x_1+x_2+x_4+x_5+x_7+x_8+x_9+1)*\alpha^5$$

$$+(x_4+x_9+x_{14}+0)*\alpha^6$$

$$+(x_0+x_3+x_4+x_5+x_{12}+x_{13}+x_{14}+0)*\alpha^7$$

$$+(x_2+x_3+x_7+x_9+x_{11}+x_{13}+x_{14}+1)*\alpha^8$$

$$+(x_0+x_3+x_5+x_8+x_{10}+x_{11}+x_{12}+x_{13}+0)*\alpha^9$$

$$+(x_2+x_3+x_5+x_7+x_8+x_9+x_{10}+x_{11}+x_{13}+x_{14}+1)*\alpha^{10}$$

$$+(x_0+x_3+x_4+x_5+x_8+x_9+x_{10}+x_{11}+0)*\alpha^{11}$$

$$+(x_1+x_2+x_3+x_7+x_8+x_{10}+x_{12}+x_{13}+1)*\alpha^{12}$$

$$+(x_0+x_2+x_3+x_4+x_6+x_7+x_8+x_9+x_{11}+x_{14}+x_{15}+1)*\alpha^{13}$$

$$+(x_0+x_6+x_{14}+x_{15}+0)*\alpha^{14}$$

$$+(x_8+x_{14}+x_{15}+0)*\alpha^{15};$$

let all the above coefficients of $\alpha^i$ be equal to 0, thus obtaining 16 equations:

$$x_0+x_2+x_4+x_5+x_6+x_7+x_8+x_{10}+x_{11}+x_{13}=1;$$

$$x_0+x_2+x_3+x_5+x_6+x_7+x_{11}+x_{12}+x_{14}+x_{15}=1;$$

$$x_1+x_2+x_6+x_7+x_8+x^9+x_{14}+x_{15}=1;$$

$$x_4+x_5+x_6+x_8+x_9+x_{10}+x_{11}+x_{13}=0;$$

$$x_0+x_2+x_3+x_4+x_6+x_7+x_8+x_{10}+x_{11}+x_{12}+x_{13}=1;$$

$$x_0+x_1+x_2+x_4+x_5+x_7+x_8+x_9=1;$$

$$x_4+x_9+x_{14}=0;$$

$$x_0+x_3+x_4+x_5+x_{12}+x_{13}+x_{14}=0;$$

$$x_2+x_3+x_7+x_9+x_{11}+x_{13}+x_{14}=1;$$

$$x_0+x_3+x_5+x_8+x_{10}+x_{11}+x_{12}+x_{13}=0;$$

$$x_2+x_3+x_5+x_7+x_8+x_9+x_{10}+x_{11}+x_{13}+x_{14}=1;$$

$$x_0+x_3+x_4+x_5+x_8+x_9+x_{10}+x_{11}=0;$$

$$x_1+x_2+x_3+x_7+x_8+x_{10}+x_{12}+x_{13}=1;$$

$$x_0+x_2+x_3+x_4+x_6+x_7+x_8+x_9+x_{11}+x_{14}+x_{15}=1;$$

$$x_0+x_6+x_{14}+x_{15}=0;$$

$$x_8+x_{14}+x_{15}=0;$$

the above 16 equations are converted into a non-homogeneous linear equation set for $x_i$, and a matrix consisting of the coefficients of $x_i$' and numerical values of constant terms is obtained:

$$\begin{bmatrix} 1 & 0 & 1 & 0 & 1 & 1 & 1 & 1 & 1 & 0 & 1 & 1 & 0 & 1 & 0 & 0 \\ 1 & 0 & 1 & 1 & 0 & 1 & 1 & 1 & 0 & 0 & 0 & 1 & 1 & 0 & 1 & 1 \\ 0 & 1 & 1 & 0 & 0 & 0 & 1 & 1 & 1 & 0 & 0 & 0 & 0 & 1 & 1 \\ 0 & 0 & 0 & 0 & 1 & 1 & 1 & 0 & 1 & 1 & 1 & 0 & 1 & 0 & 0 \\ 1 & 0 & 1 & 1 & 1 & 0 & 1 & 1 & 1 & 0 & 1 & 1 & 1 & 0 & 0 \\ 1 & 1 & 1 & 0 & 1 & 1 & 0 & 1 & 1 & 1 & 0 & 0 & 0 & 0 & 0 \\ 0 & 0 & 0 & 0 & 1 & 0 & 0 & 0 & 0 & 1 & 0 & 0 & 0 & 0 & 1 & 0 \\ 1 & 0 & 0 & 1 & 1 & 1 & 0 & 0 & 0 & 0 & 0 & 1 & 1 & 1 & 0 \\ 0 & 0 & 1 & 1 & 0 & 0 & 0 & 1 & 0 & 1 & 0 & 1 & 0 & 1 & 1 & 0 \\ 1 & 0 & 0 & 1 & 0 & 1 & 0 & 0 & 1 & 0 & 1 & 1 & 1 & 1 & 0 & 0 \\ 0 & 0 & 1 & 1 & 0 & 1 & 0 & 1 & 1 & 1 & 1 & 1 & 0 & 1 & 1 & 0 \\ 1 & 0 & 0 & 1 & 1 & 1 & 0 & 0 & 1 & 1 & 1 & 1 & 0 & 0 & 0 & 0 \\ 0 & 1 & 1 & 1 & 0 & 0 & 0 & 1 & 1 & 0 & 1 & 0 & 1 & 1 & 0 & 0 \\ 1 & 0 & 1 & 1 & 1 & 0 & 1 & 1 & 1 & 1 & 0 & 1 & 0 & 0 & 1 & 1 \\ 1 & 0 & 0 & 0 & 0 & 0 & 1 & 0 & 0 & 0 & 0 & 0 & 0 & 0 & 1 & 1 \\ 0 & 0 & 0 & 0 & 0 & 0 & 0 & 1 & 0 & 0 & 0 & 0 & 0 & 1 & 1 \end{bmatrix} \begin{matrix} 1 \\ 1 \\ 1 \\ 0 \\ 1 \\ 1 \\ 0 \\ 0 \\ 1 \\ 0 \\ 1 \\ 0 \\ 1 \\ 1 \\ 0 \\ 0 \end{matrix} ;$$

the above non-homogeneous linear equation set is solved to obtain $x_1$=0x0004, $x_2$=0x0080;

in the lookup table $f(\alpha^j)$, the locations corresponding to $x_1$ and $x_2$ are the second power of $\alpha$ and the seventh power of $\alpha$ respectively; thus, the locations of the error information codes in the code word polynomial Q(x) are the coefficients corresponding to the second power and the seventh power of x, namely, 0xa513 and 0xe305.

If no values that are the same as the values of $x_1$ and $x_2$ are found in the lookup table $f(\alpha^j)$, the following method is used to find out the location of the error code, specifically:

in step S1, take p=2*m-1=31, v=$\alpha^{2m-1}$=0x823e;
in step S2, let p=p + 1;
in step S3, if the highest data bit of v is 1, v is firstly shifted leftward by 1 bit, and then v=v+0x1d, where 0x1d is the numerical value obtained by bringing x=$\alpha$ into $x^5+x^3+x^2+1$ in the primitive polynomial $P(x)=x^{16}+x^5+x^3+x^2+1$;
if the highest data bit of v is 0, v is shifted leftward by 1 bit;
in step S4, the v obtained in step S3 is compared with $x_1$ or $x_2$ to see if they are equal:

if the v is equal to $x_1$ or $x_2$, the coefficient corresponding to the $p^{th}$ power of x in the code word polynomial Q(x) is the location of the error information code; and
If the v is not equal to $x_1$ or $x_2$, then turn to step S2 to continue the process.

The error value is calculated according to the following two equations:

$$S_1 = e_1 \cdot x_1 + e_2 \cdot x_2 = 0xed82 ;$$

$$S_2 = e_1 \cdot x_1^2 + e_2 \cdot x_2^2 = 0xc556 ;$$

values of $x_1$ and $x_2$ are brought into the above two equations to yield $e_1$=0x9094 and $e_2$=0xd140, specifically:

$S_1*x_1-S_2$ is calculated to yield $(x_1 \cdot x_2 - x_2^2) \cdot e_2$ = 0xed82 - 0xc556;
$e_2$ is represented in polynomial representation as:

$$e_2 = x1_5\alpha^{15} + x_{14}\alpha^{14} + x_{13}\alpha^{13} + x_{12}\alpha^{12} + x_{11}\alpha^{11} + x_{10}\alpha^{10} + x_9\alpha^9 + x_8\alpha^8$$

$$+ x_7\alpha^7 + x_6\alpha^6 + x_5\alpha^5 + x_4\alpha^4 + x_3\alpha^3 + x_2\alpha^2 + x_1\alpha^1 + x_0\alpha^0;$$

where $x_i$ can only take 0 or 1, i=1, 2, ..., 15;

the value of $e_2$ is brought into $(x_1 \cdot x_2 - x_2^2) \cdot e_2 = 0xed82 - 0xc556$ to obtain the non-homogeneous linear equation set and yield $e_2 = 0xd140$;

and in a similar principle, yield $e_1 = 0x9094$;

the correction value is added to the code word at the location of the error information code received by the receiving terminal to obtain error-corrected code word, specifically:

in the error-corrected code word polynomial Q(x), the coefficient of the second power of x is: $0xa513 + 0x9094 = 0x3587$, and the coefficient of the seventh power of x is: $0xe305 + 0xd140 = 0x3245$;

the value of the error-corrected code word is assigned to the code word at the location of the error information code so as to obtain the error-corrected code word polynomial Q(x) as follows:

$$Q(x) = 0x1234 * x^9 + 0x5678 * x^8 + 0x3245 * x^7 + 0xabcd * x^6 + 0xef10 * x^5$$
$$+ 0x15d4 * x^4 + 0x2606 * x^3 + 0x3587 * x^2 + 0x417e * x^1 + 0x121c * x^0 ;$$

$S_5 = Q(\alpha^5)$ is recalculated, and if $S_5 = 0$ is yielded, the error correction is successful.

To sum up, in the RS error correction decoding method according to the present invention, a lookup table $f(\alpha^j)$ for different power exponents of $\alpha$ is established, where j is selected from all the integers ranging from 0 to 2m-1, and with a total number of 2m, for the calculation of the coefficients of the generator polynomial G(x) and the coefficients of the remainder polynomial R(x) obtained by dividing the code word polynomial Q(x) by the generator polynomial G(x), thus greatly saving system memory; one additional redundant code is taken in encoding, for the purpose of checking the data obtained after the error correction decoding, thereby improving correctness and stability of the system.

## Claims

1. A Reed-Solomon, RS, error correction encoding and decoding method, wherein, when encoding at a sending terminal, the following holds:

   • code words of information data are represented by $K_l$,
   • code words of redundant codes are represented by $T_n$,
   • the order of primitive polynomial P(x) is m,
   • a generator polynomial in $GF(2^m)$ is G(x), and
   • an error correction code is represented by (c, k, t),
   wherein c is the total length of the information data and the redundant code, k is the length of the information data, and t is the length of the redundant code, then

   • the code word polynomial Q(x) can be represented as

   $$Q(x) = \sum_{l=t}^{t+k-1} K_l \cdot x^l + \sum_{n=0}^{t-1} T_n \cdot x^n ;$$

   • a root of the m-order primitive polynomial P(x) is a primitive field element in $GF(2^m)$, and the primitive field element is represented by $\alpha$, thus the generator polynomial G(x) can be represented as

$$G(\mathrm{x}) = \prod_{i=1}^{t}\left(x - \alpha^{i}\right) ;$$

the method including the steps of:

• establishing one lookup table $f(\alpha^j)$ including different powers $\alpha^j$, of $\alpha$, for j = 0, 1, ..., 2m-1, i.e. $f(\alpha^j) = \{\alpha^0, \alpha^1, ..., \alpha^{(2m-1)}\}$;
• expanding the generator polynomial G(x) to obtain a polynomial with respect to x, wherein the coefficients of the generator polynomial G(x) are the addition or subtraction of the powers of $\alpha$; wherein numerical values of the different powers of $\alpha$ are found out through the lookup table $f(\alpha^j)$ and the coefficients of the generator polynomial G(x) are calculated; and wherein it is assumed that the code words $T_n$ of the redundant codes are all 0, then a code word polynomial

$$Q(x) = \sum_{l=t}^{t+k-1} K_l \cdot x^l$$

is obtained;
• dividing the code word polynomial Q(x) by the generator polynomial G(x) to obtain a remainder polynomial

$R(x) = \sum_{n=0}^{t-1} T_n x^n$ , wherein the coefficients $T_n$ of R(x) are the addition or subtraction of the powers of $\alpha$; and wherein numerical values of the powers of $\alpha$ are found out through the lookup table $f(\alpha^j)$, and the coefficients $T_n$ of the remainder polynomial R(x) are calculated.

2. The RS error correction encoding and decoding method according to claim 1, wherein:

•

$$t=2s+1;;$$

the method further comprising the steps of:

• sending, by the sending terminal, code words of information data $K_l$, l=2s+1, ..., 2s+k, and 2s+1 codes words of redundant codes $T_n$, n=0, ..., 2s, to the receiving terminal;
• receiving, by the receiving terminal, the code words of information data and 2s+1 code words of redundant codes;
• obtaining, by the receiving terminal, the code word polynomial Q(x) according to the received code words of information data and 2s+1 code words of redundant codes, and the code word polynomial Q(x) being represented as:

$$Q(x) = \sum_{l=2s+1}^{2s+k} K_l \cdot x^l + \sum_{n=0}^{2s} T_n \cdot x^n .$$

• calculating, by the receiving terminal, 2s+1 correctors $S_i$, wherein $S_i=Q(\alpha^i)$, i=1, 2, ..., 2s+1;
• calculating a location of an error information code and a correction value using correctors $S_i$ to $S_{2s}$, if not all of the correctors $S_i$ are equal to 0,

wherein the location of the error information code indicates a position of a coefficient in the obtained code word polynomial Q(x) that is in error;

• adding the correction value to the coefficient of the code word polynomial obtained by the receiving terminal, which coefficient is indicated by the location of the error information code received by the receiving terminal to obtain an error-corrected coefficient of the code word polynomial;

• assigning a value of the error-corrected coefficient of the code word polynomial to the obtained code word polynomial at the location of the error information code;

• recalculating $S_{2s+1}=Q'(\alpha^{2s+1})$, wherein Q' indicates the error-corrected code word polynomial, and wherein if $S_{25+1}=0$, the error correction is successful.

3. The RS error correction encoding and decoding method according to claim 1, wherein in the process of obtaining the remainder polynomial R(x) by dividing the code word polynomial Q(x) by the generator polynomial G(x), multiplication of the coefficients of x is performed, and the multiplication operation is converted into addition operation specifically as follows:

• representing the coefficients of x by a polynomial representation;

• multiplying and expanding the coefficients represented by the polynomial representation to obtain an addition of different powers of $\alpha$;

• finding out the numerical values of the different powers of $\alpha$ through the lookup table $f(\alpha^j)$ to solve the addition.

4. The RS error correction encoding and decoding method according to claim 2, wherein the process of calculating the location of the error information code using the correctors $S_1$ to $S_{2s}$ is specifically performed as follows:

• calculating, based on the correctors, an equation such that the location of the error information code is a root of the equation;

• representing the root of the equation by a polynomial representation, with standard bases being different powers of $\alpha$, $\alpha^0$, $\alpha^1$, ..., $\alpha^{(2m-1)}$, and coefficients being values of Xi, where Xi is 0 or 1, and wherein i=0, 1, ..., m;

• representing the coefficients of the equation by the polynomial representation, with standard bases being different powers of $\alpha$, $\alpha^0$, $\alpha^1$, ..., $\alpha^{(2m1)}$;

• bringing the root and coefficients represented by the polynomial representation into the polynomial of the equation;

• letting the coefficient of each term of the polynomial be zero, thus obtaining a non-homogeneous linear equation set for $x_i$;

• solving the non-homogeneous linear equation set to obtain the value of $x_i$;

• substituting the value of $x_i$ into the root represented by the polynomial representation to obtain by calculation the root of the equation so as to obtain the location of the error information code;

• looking for the location in the code word polynomial Q(x) corresponding to the location of the error information code.

5. The RS error correction encoding and decoding method according to claim 4, wherein looking for the location in the code word polynomial Q(x) corresponding to the location of the error information code specifically includes:

• finding out the numerical value in the lookup table $f(\alpha^j)$ that is the same as the value of the error information code, the coefficient at the location where the exponent value of x in the polynomial Q(x) is equal to the exponent value of $\alpha$ corresponding to the numerical value is the location in the code word polynomial Q(x) corresponding to the error information code;

• if the numerical value that is the same as the value of the error information code is not found in the lookup table $f(\alpha^j)$, the following method is used to find out the location of the error information code, specifically:

• S1, taking p=2*m-1=31, $v=\alpha^{2m-1}$;

• S2, letting p=p + 1;

• S3, if the highest data bit of v is 1, shifting v leftward by 1 bit firstly, and then $v=v+v_0$, wherein $v_0$ is the numerical value obtained by bringing $x=\alpha$ into the primitive polynomial P(x) except for the term of the highest power of x;

• if the highest data bit of v is 0, shifting v leftward by 1 bit;

• S4, comparing the v obtained in step S3 with the error information code to see whether they are equal:

• If the v is equal to the error information code, the coefficient corresponding to the $p^{th}$ power of x in the code word polynomial Q (x) is the location of the error information code.

• If the v is not equal to the error information code, then turn to step S2 to continue the process.

**Patentansprüche**

1. Ein Reed-Solomon, RS, Fehlerkorrektur-Codier- und Decodierverfahren, wobei bei der Verschlüsselung an einem sendenden Endgerät Folgendes gilt:

   • die Codewörter der Informationsdaten werden durch $K_l$ dargestellt,
   • die Codewörter der redundanten Codes werden durch $T_n$ dargestellt,
   • die Ordnung des primitiven Polynoms P(x) ist m,
   • ein Generatorpolynom in $GF(2^m)$ ist G(x), und
   • ein Fehlerkorrekturcode wird durch (c, k, t) dargestellt,
   wobei c die Gesamtlänge der Informationsdaten und des redundanten Codes ist, k die Länge der Informationsdaten ist und t die Länge des redundanten Codes ist, dann

   • kann das Codewortpolynom Q(x) als

   $$Q(x) = \sum_{l=t}^{t+k-1} K_l \cdot x^l + \sum_{n=0}^{t-1} T_n \cdot x^n$$

   dargestellt werden;
   • ist eine Wurzel des primitiven Polynoms P(x) der Ordnung m ein primitives Feldelement in $GF(2^m)$, und das primitive Feldelement wird durch $\alpha$ dargestellt, daher kann das Generatorpolynom G(x) wie folgt dar-gestellt werden

   $$G(x) = \prod_{i=1}^{t} (x - \alpha^i)$$
   ;

   wobei das Verfahren die folgenden Schritte umfasst:

   • Erstellen einer Nachschlagetabelle $f(\alpha^j)$ mit verschiedenen Potenzen, $\alpha^j$, von $\alpha$, für j = 0, 1, ..., 2m-1, d.h. $f(\alpha^j) = \{ \alpha, \alpha^{01}, ..., \alpha^{(2m-1)} \}$;
   • Expandieren des Generatorpolynoms G(x), um ein Polynom in Bezug auf x zu erhalten, wobei die Koeffizienten des Generatorpolynoms G(x) die Addition oder Subtraktion der Potenzen von $\alpha$ sind; wobei nu-merische Werte der verschiedenen Potenzen von $\alpha$ durch die Nachschlagetabelle $f(\alpha^j)$ herausgefunden werden und die Koeffizienten des Generatorpolynoms G(x) berechnet werden; und wobei angenommen wird, dass die Codewörter $T_n$ der redundanten Codes alle 0 sind, dann wird ein Codewortpolynom

   $$Q(x) = \sum_{l=t}^{t+k-1} K_l \cdot x^l$$

   erhalten;
   • Dividieren des Codewortpolynoms Q(x) durch das Generatorpolynom G(x), um ein Restpolynom $R(x) = \sum_{n=0}^{t-1} T_n x^n$ zu erhalten, wobei die Koeffizienten $T_n$ von R(x) die Addition oder Subtraktion der Potenzen von $\alpha$ sind; und wobei numerische Werte der Potenzen von $\alpha$ durch die Nachschlagetabelle $f(\alpha^j)$ herausgefunden werden, und die Koeffizienten $T_n$ des Restpolynoms R(x) berechnet werden.

2. RS-Fehlerkorrektur-Codier- und Decodierverfahren nach Anspruch 1, wobei:

   •

$$t = 2s + 1;$$

wobei das Verfahren außerdem die folgenden Schritte umfasst:

- Senden von Codewörtern von Informationsdaten $K_l$, $l=2s+1, ..., 2s+k$, und $2s+1$ Codewörtern von redundanten Codes $T_n$, $n=0, ..., 2s$, durch das sendende Endgerät an das empfangende Endgerät;
- Empfang der Codewörter der Informationsdaten und $2s+1$ Codewörter der redundanten Codes durch das empfangende Endgerät;
- Erhalten des Codewortpolynoms Q(x) durch das empfangende Endgerät gemäß den empfangenen Codewörtern von Informationsdaten und $2s+1$ Codewörtern von redundanten Codes, und wobei das Codewortpolynom Q(x) dargestellt wird als:

$$Q(x) = \sum_{l=2s+1}^{2s+k} K_l \cdot x^l + \sum_{n=0}^{2s} T_n \cdot x^n ;$$

- Berechnen von $2s+1$ Korrektoren $S_i$ durch das empfangende Endgerät, wobei $S_i = Q(\alpha^i)$, $i=1, 2, ..., 2s+1$;
- Berechnen der Stelle eines Fehlerinformationscodes und eines Korrekturwertes unter Verwendung der Korrektoren $S_1$ bis $S_{2s}$, wenn nicht alle Korrektoren $S_i$ gleich 0 sind, wobei die Stelle des Fehlerinformationscodes eine Stelle eines Koeffizienten in dem erhaltenen Codewortpolynom Q(x) angibt, die fehlerhaft ist;
- Addieren des Korrekturwerts zum Koeffizienten des vom empfangenden Endgerät erhaltenen Codewortpolynoms, wobei der Koeffizient durch die Stelle des vom empfangenden Endgerät empfangenen Fehlerinformationscodes angegeben wird, um einen fehlerkorrigierten Koeffizienten des Codewortpolynoms zu erhalten;
- Zuordnen eines Wertes des fehlerkorrigierten Koeffizienten des Codewortpolynoms zu dem erhaltenen Codewortpolynom an der Stelle des Fehlerinformationscodes;
- Neuberechnen von $S_{2s+1} = Q'(\alpha^{2s+1})$, wobei Q' das fehlerkorrigierte Codewortpolynom angibt, und wobei, wenn $S_{2s+1}=0$, die Fehlerkorrektur erfolgreich ist.

3. RS-Fehlerkorrekturkodier- und -dekodierverfahren nach Anspruch 1, wobei in dem Prozess der Gewinnung des Restpolynoms R(x) durch Dividieren des Codewortpolynoms Q(x) durch das Generatorpolynom G(x) eine Multiplikation der Koeffizienten von x durchgeführt wird und die Multiplikationsoperation in eine Additionsoperation umgewandelt wird, und zwar wie folgt:

- Darstellen der Koeffizienten von x durch eine Polynomdarstellung;
- Multiplizieren und Expandieren der durch die Polynomdarstellung repräsentierten Koeffizienten, um eine Addition verschiedener Potenzen von $\alpha$ zu erhalten;
- Ermitteln der Zahlenwerte der verschiedenen Potenzen von $\alpha$ mit Hilfe der Nachschlagetabelle $f(\alpha^j)$ zur Lösung der Addition.

4. RS-Fehlerkorrekturkodier- und -dekodierverfahren nach Anspruch 2, wobei der Prozess der Berechnung der Stelle des Fehlerinformationscodes unter Verwendung der Korrektoren $S_1$ bis $S_{2s}$ konkret wie folgt durchgeführt wird:

- Berechnen einer Gleichung auf der Grundlage der Korrektoren, so dass die Stelle des Fehlerinformationscodes eine Wurzel der Gleichung ist;
- Darstellung der Wurzel der Gleichung durch eine Polynomdarstellung, wobei die Standardbasen verschiedene Potenzen von $\alpha$ sind, $\alpha^0$, $\alpha^1$, ..., $\alpha^{(2m-1)}$, und die Koeffizienten Werte von Xi sind, wobei Xi 0 oder 1 ist, und wobei $i=0, 1, ..., m$;
- Darstellung der Koeffizienten der Gleichung durch die Polynomdarstellung, wobei die Standardbasen verschiedene Potenzen von $\alpha$ sind, $\alpha^0$, $\alpha^1$, ..., $\alpha^{(2m-1)}$.
- Bringen der Wurzel und der Koeffizienten, die durch die Polynomdarstellung repräsentiert werden, in das Polynom der Gleichung;
- Setzen des Koeffizienten jedes Terms des Polynoms zu Null, so dass sich eine nicht homogene lineare Gleichung für $x_i$ ergibt;
- Lösen der nicht-homogenen linearen Gleichung, um den Wert von $x_i$ zu erhalten;

• Einsetzen des Wertes von $x_i$ in die durch die Polynomdarstellung dargestellte Wurzel, um durch Berechnung die Wurzel der Gleichung zu erhalten und so die Stelle des Fehlerinformationscodes zu ermitteln;
• Suche nach der Stelle im Codewortpolynom Q(x), die der Stelle des Fehlerinformationscodes entspricht.

**5.** RS-Fehlerkorrekturkodier- und -dekodierverfahren nach Anspruch 4, wobei die Suche nach der Stelle im Codewortpolynom Q(x), die der Stelle des Fehlerinformationscodes entspricht, konkret umfasst:

• Ermitteln des numerischen Werts in der Nachschlagetabelle $f(\alpha^j)$, der mit dem Wert des Fehlerinformationscodes übereinstimmt, wobei der Koeffizient an der Stelle, an der der Exponentenwert von x im Polynom Q(x) gleich dem Exponentenwert von $\alpha$ ist, der dem numerischen Wert entspricht, die Stelle im Codewortpolynom Q(x) ist, die dem Fehlerinformationscode entspricht;
• wobei, wenn der Zahlenwert, der mit dem Wert des Fehlerinformationscodes übereinstimmt, nicht in der Nachschlagetabelle $f(\alpha^j)$ gefunden wird, die folgende Methode verwendet wird, um die Stelle des Fehlerinformationscodes zu ermitteln:

• S1, mit p=2*m-1=31, $v=\alpha^{2m-1}$;
• S2, wobei p=p + 1 ist;
• S3, wenn das höchste Datenbit von v 1 ist, zunächst Verschieben von v um 1 Bit nach links, und dann ist $v=v+v_0$, wobei $v_0$ der numerische Wert ist, den man erhält, wenn man $x=\alpha$ in das primitive Polynom P(x) bringt, mit Ausnahme des Terms der höchsten Potenz von x;
• wenn das höchste Datenbit von v 0 ist, Verschieben von v um 1 Bit nach links;
• S4, Vergleichen des in Schritt S3 erhaltenen v mit dem Fehlerinformationscode, um festzustellen, ob sie gleich sind:

• wenn v gleich dem Fehlerinformationscode ist, ist der Koeffizient, der der p-ten Potenz von x im Codewortpolynom Q (x) entspricht, die Stelle des Fehlerinformationscodes.
• wenn v nicht dem Fehlerinformationscode entspricht, Gehen zu Schritt S2, um den Vorgang fortzusetzen.

## Revendications

**1.** Un procédé de codage et de décodage de correction d'erreurs, de Reed-Solomon, RS, dans lequel :

lors d'un codage sur un terminal d'envoi, ce qui suit s'applique :

• les mots de code des données d'information sont représentés par $K_l$,
• les mots de code des codes redondants sont représentés par $T_n$,
• l'ordre du polynôme primitif P(x) est m,
• un polynôme générateur dans $GF(2^m)$ est G(x), et
• un code de correction d'erreur est représenté par (c, k, t),

c étant la longueur totale des données d'informations et du code redondant, k étant la longueur des données d'informations et t étant la longueur du code redondant, alors

• le polynôme de mot de code Q(x) peut être représenté par

$$Q(x) = \sum_{l=t}^{t+k-1} K_l \cdot x^l + \sum_{n=0}^{t-1} T_n \cdot x^n ,$$

• une racine du polynôme primitif d'ordre m P(x) est un élément de champ primitif dans $GF(2^m)$, et l'élément de champ primitif est représenté par $\alpha$, donc le polynôme générateur G(x) est apte à être représenté comme

$$G(\mathrm{x}) = \prod_{i=1}^{t}\left(x - \alpha^{i}\right) \ ;$$

le procédé comprenant les étapes suivantes :

• établir une table de recherche $f(\alpha^j)$ comprenant différentes puissances, $\alpha^j$ de $\alpha$, pour j = 0, 1, ..., 2m-1, soit $f(\alpha^j) = \{ \alpha^0, \alpha^1, ... , \alpha^{(2m-1)}\}$ ;
• étendre le polynôme générateur G(x) pour obtenir un polynôme par rapport à x, les coefficients du polynôme générateur G(x) étant l'addition ou la soustraction des puissances de $\alpha$ ; des valeurs numériques des différentes puissances de $\alpha$ sont trouvées via la table de recherche $f(\alpha^j)$ et les coefficients du polynôme générateur G(x) sont calculés ; et il est supposé que les mots de code $T_n$ des codes redondants sont tous égaux à 0, alors un polynôme de mot de code

$$Q(x) = \sum_{l=t}^{t+k-1} K_l \cdot x^l$$

est obtenu ;
• diviser le polynôme de mot de code Q(x) par le polynôme générateur G(x) pour obtenir un polynôme reste

$$R(x) = \sum_{n=0}^{t-1} T_n x^n$$ , les coefficients $T_n$ de R(x) étant l'addition ou la soustraction des puissances de $\alpha$ ; et des valeurs numériques des puissances de $\alpha$ sont trouvées via la table de recherche $f(\alpha^j)$, et les coefficients $T_n$ du polynôme restant R(x) sont calculés.

2. Le procédé de codage et de décodage de correction d'erreur RS selon la revendication 1, dans lequel :

•

$$t=2s+1 \ ;$$

le procédé comprenant en outre les étapes suivantes :

• envoyer, par le terminal émetteur, au terminal receveur, des mots de code de données d'information $K_l$, l=2s+1, ..., 2s+k, et 2s+1 mots de code de codes redondants $T_n$, n=0,..., 2s ;
• recevoir, par le terminal receveur, les mots de code de données d'informations et 2s+1 mots de code de codes redondants ;
• obtenir, par le terminal receveur, le polynôme de mot de code Q(x) en fonction des mots de code reçus de données d'information et de 2s+1 mots de code de codes redondants, et le polynôme de mot de code Q(x) étant représenté comme étant :

$$Q(x) = \sum_{l=2s+1}^{2s+k} K_l \cdot x^l + \sum_{n=0}^{2s} T_n \cdot x^n \ ;$$

• calculer, par le terminal receveur, 2s+1 correcteurs Si, dans lequel $S_i=Q(\alpha^j)$, i=1, 2,..., 2s+1 ;
• calculer un emplacement d'un code d'informations d'erreur et une valeur de correction en utilisant des correcteurs $S_1$ à $S_{2s}$, si tous les correcteurs $S_i$ ne sont pas égaux à 0, l'emplacement du code d'informations d'erreur indiquant une position d'un coefficient dans le polynôme de mot de code Q(x) obtenu qui est une erreur ;
• ajouter la valeur de correction au coefficient du polynôme de mot de code obtenu par le terminal receveur, lequel coefficient est indiqué par l'emplacement du code d'informations d'erreur reçu par le terminal receveur pour obtenir un coefficient corrigé d'erreur du polynôme de mot de code ;
• attribuer une valeur du coefficient corrigé d'erreur du polynôme de mot de code au polynôme de mot de code obtenu à l'emplacement du code d'informations d'erreur ;
• recalculer $S_{2s+1} = Q'(\alpha^{2s+1})$, dans lequel Q' indique le polynôme de mot de code corrigé des erreurs, et dans lequel si $S_{2s+1}=0$, la correction d'erreur est réussie.

3. Le procédé de codage et de décodage de correction d'erreur RS selon la revendication 1, dans lequel, dans le processus d'obtention du polynôme reste R(x) en divisant le polynôme de mot de code Q(x) par le polynôme générateur G(x), une multiplication des coefficients de x est effectuée, et l'opération de multiplication est convertie en une opération d'addition spécifiquement comme suit :

   • représenter les coefficients de x par une représentation polynomiale ;
   • multiplier et étendre les coefficients représentés par la représentation polynomiale pour obtenir une addition de différentes puissances de $\alpha$ ;
   • trouver les valeurs numériques des différentes puissances de $\alpha$ via la table de recherche $f(\alpha^j)$ pour résoudre l'addition.

4. Le procédé de codage et de décodage de correction d'erreur RS selon la revendication 2, dans lequel le processus de calcul de l'emplacement du code d'information d'erreur en utilisant des correcteurs $S_1$ à $S_{2s}$ est spécifiquement effectué comme suit :

   • calculer, sur la base des correcteurs, une équation de telle sorte que l'emplacement du code d'informations d'erreur soit une racine de l'équation ;
   • représenter la racine de l'équation par une représentation polynomiale, les bases standards étant différentes puissances de $\alpha$, $\alpha^0, \alpha^1, ..., \alpha^{(2m-1)}$ et les coefficients étant des valeurs de Xi, Xi étant 0 ou 1, et i = 0, 1,..., m ;
   • représenter les coefficients de l'équation par la représentation polynomiale, les bases standards étant différentes puissances de $\alpha$, $\alpha^0, \alpha^1,..., \alpha^{(2m-1)}$ ;
   • amener la racine et les coefficients représentés par la représentation polynomiale dans le polynôme de l'équation ;
   • laisser le coefficient de chaque terme du polynôme être nul, obtenant ainsi une équation linéaire non homogène définie pour $x_i$ ;
   • résoudre l'ensemble d'équations linéaires non homogènes pour obtenir la valeur de $x_i$ ;
   • remplacer la valeur de $x_i$ dans la racine représentée par la représentation polynomiale pour obtenir par calcul la racine de l'équation de manière à obtenir l'emplacement du code d'informations d'erreur ;
   • rechercher l'emplacement dans le polynôme de mot de code Q(x) correspondant à l'emplacement du code d'information d'erreur.

5. Le procédé de codage et de décodage de correction d'erreur RS selon la revendication 4, dans lequel la recherche de l'emplacement dans le polynôme de mot de code Q(x) correspondant à l'emplacement du code d'information d'erreur comprend spécifiquement :

   • le fait de trouver la valeur numérique dans la table de recherche $f(\alpha^j)$ qui est la même que la valeur du code d'information d'erreur, le coefficient à l'emplacement où la valeur de l'exposant de x dans le polynôme Q(x) est égale à la valeur de l'exposant de $\alpha$ correspondant à la valeur numérique est l'emplacement dans le polynôme de mot de code Q(x) correspondant au code d'informations d'erreur ;
   • si la valeur numérique qui est la même que la valeur du code d'information d'erreur n'est pas trouvée dans la table de recherche $f(\alpha^j)$, le procédé suivant est utilisé pour connaître l'emplacement du code d'information d'erreur, spécifiquement :

      • S1, en prenant p=2*m-1=31, $v=\alpha^{2m-1}$ ;
      • S2, en faisant que p=p+1 ;
      • S3, si le bit de données le plus élevé de v est 1, décaler v vers la gauche de 1 bit d'abord, puis $v=v+v_0$, $v_0$ étant la valeur numérique obtenue en amenant $x=\alpha$ dans le polynôme primitif P(x) à l'exception du terme de la plus haute puissance de x ;
      • si le bit de données le plus élevé de v est 0, décaler v vers la gauche de 1 bit ;
      • S4, en comparant le v obtenu à l'étape S3 avec le code d'informations d'erreur pour voir s'ils sont égaux :

         • si v est égal au code d'informations d'erreur, le coefficient correspondant à la $p^{ième}$ puissance de x dans le polynôme de mot de code Q(x) est l'emplacement du code d'informations d'erreur.
• si v n'est pas égal au code d'information d'erreur, il y a alors lieu de passer à l'étape S2 pour continuer le processus.

establish a primitive polynomial P(x), a generator polynomial G(x), and a code word polynomial Q(x) according to information data

establish a lookup table $f(a^j)$ for different power exponents of a, the value of j being selected from all the integers ranging from 0 to 2m-1, with a total number of 2m

expand the generator polynomial G(x) to obtain a polynomial with respect to x

find out numerical values of different power exponents of a through the lookup table $f(a^j)$ and calculate the coefficients of the generator polynomial G(x)

assume that the code words $T_n$ of the redundant codes are all 0 so as to obtain the code word polynomial Q(x)

divide the code word polynomial Q(x) by the generator polynomial G(x) to obtain a remainder polynomial R(x)

find out numerical values of the power exponents of a through the lookup table $f(a^j)$ and calculate coefficients of the remainder polynomial R(x), i.e., the code words $T_n$ of the redundant codes

Figure 1

Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 1303763 C
- WO 0117154 A2
- US 6263470 B1

**Non-patent literature cited in the description**

- **C.K.P. CLARKE.** Reed-Solomon error correction. *BBC R&D White Paper, WHP 031,* July 2002